# EUROPEAN PATENT APPLICATION

(11) **EP 2 053 737 A2**
(43) Date of publication of application: **29.04.2009**
(21) Application number: 08253261.5
(22) Date of filing: 07.10.2008
(51) Int. Cl.: H03D 7/16

(54) **Signal processing device and method, and digital broadcast receiving device, and method**

(30) Priority: 22.10.2007 JP 2007274093
(71) Applicant: Sony Corporation, Tokyo 108-0075 (JP)
(72) Inventor: Minamino, Takanori, Tokyo (JP); Ikeda, Tamotsu, Tokyo (JP)
(74) Representative: Scaddan, Gareth Casey

(57) **Abstract**

A signal processing device includes: a first converting unit for frequency-converting the input signal into a signal in a first frequency band; a filter for cutting off the frequency component outside a predetermined pass band; a second converting unit for frequency-converting the signal from the first frequency band to a second frequency band; third converting unit for converting the signal in the second frequency band into a signal in a third frequency band coinciding with the pass band; an oscillating unit for oscillating a signal used for frequency conversion of the third converting unit; and a detecting unit for detecting a frequency error between oscillation frequency of the signal oscillated by the oscillating unit and frequency of a signal used for frequency conversion from the second frequency band to the third frequency band coinciding with the pass band, and outputting an error signal indicating the frequency error.

## Description

### Field of the Invention

The present invention relates to a signal processing device and method, and a digital broadcast receiving device and method. Embodiments of the present invention relate to a signal processing device for cutting off a predetermined frequency component of an input signal, and a digital broadcast receiving device for receiving a digital broadcast wave, the digital broadcast receiving device incorporating the signal processing device.

### Background of the Invention

A digital broadcast receiving device for receiving a digital broadcast wave needs to cut off a signal outside a band using a band-pass filter or a low-pass filter in order to avoid interference of an adjacent channel. In a digital broadcast receiving device in particular, the pass band of a cutoff filter needs to be narrowed to enhance resistance to interference of an adjacent channel.

However, when the pass band is narrowed, and a received signal is frequency-converted into a frequency band greatly shifted from a desired frequency band due to the performance of an oscillator that oscillates a signal, a desired received signal component is cut off by a cutoff filter, and therefore correct demodulation processing cannot be performed.

In order to solve this problem, Japanese Patent Laid-Open No. Hei 10-313344 (hereinafter referred to as Patent Document 1) describes a receiver that detects a frequency shift from the output of a cutoff filter, prevents degradation due to the frequency shift by feeding back the amount of the shift to a local oscillator in a stage preceding the cutoff filter, and widens a followable frequency range by adaptively changing the bandwidth of the cutoff filter according to the amount of the detected frequency shift.

In addition, Japanese Patent Laid-Open No. 2001-127818 (hereinafter referred to as Patent Document 2) describes a digital signal processing method that detects the offset frequency of an oscillated signal from a local oscillator, and adaptively changes the coefficient of a cutoff filter using the detected offset frequency.

### Summary of the Invention

Various respective aspects and features of the invention are defined in the appended claims. Combinations of features from the dependent claims may be combined with features of the independent claims as appropriate and not merely as explicitly set out in the claims.

In the receiver described in the above Patent Document 1, a feedback system is formed with a process of adjusting the oscillation frequency of the local oscillator, a filtering process by the cutoff filter, frequency shift detection based on a filtered signal, and the adjustment of the oscillation frequency of the local oscillator using a result of the detection in this order. Therefore a delay time from the adjustment of an offset frequency to the detection of a frequency shift is lengthened. Thus, this receiver has problems in that depending on a method of the frequency shift detection, a range of frequencies that can be pulled in is narrowed, and following performance for temporal change in oscillation frequency is degraded.

The digital signal processing method described in the above Patent Document 2 needs to continue calculating a filter coefficient in response to variations in the offset frequency. In addition, because the digital signal processing method needs an adaptive type digital filter with a variable complex coefficient, there is a problem in that the scale of a circuit when realized by hardware is increased.

Embodiments of the present invention have been made in view of such an actual situation. It is desirable to provide a signal processing device, a control method of the signal processing device, a digital broadcast receiving device, and a control method of the digital broadcast receiving device that cut off a frequency component outside the pass band of a filter accurately by following a shift in frequency band of an input signal with respect to the pass band of the filter while preventing an increase in circuit scale.

According to an embodiment of the present invention, there is provided a signal processing device for cutting off a predetermined frequency component of an input signal. The signal processing device includes: a first converting unit for frequency-converting the input signal into a signal in a first frequency band; a filter for cutting off the frequency component outside a predetermined pass band, the frequency component being included in the signal in the first frequency band which signal is frequency-converted by the first converting unit; a second converting unit for frequency-converting the signal whose frequency component outside the pass band is cut off by the filter from the first frequency band to a second frequency band; a third converting unit for converting the signal in the second frequency band which signal is frequency-converted by the second converting unit into a signal in a third frequency band coinciding with the pass band; an oscillating unit for oscillating a signal used for frequency conversion of the third converting unit; and a detecting unit for detecting a frequency error between oscillation frequency of the signal oscillated by the oscillating unit and frequency of a signal used for frequency conversion from the second frequency band to the third frequency band coinciding with the pass band, and outputting an error signal indicating the frequency error. Oscillation frequency of the oscillating unit is controlled according to the error signal output by the detecting unit, and the oscillating unit oscillates the signal used to frequency-convert the second frequency band to the third frequency band coinciding with the pass band. The first converting unit is controlled according to the error signal output from the detecting unit, and frequency-converts the input signal into the signal in the first frequency band coinciding with the pass band. The second converting unit is controlled according to the error signal output from the detecting unit and delayed by a delay time taken by processing of the filter, and frequency-converts the signal whose frequency component outside the pass band is cut off by the filter from the frequency band coinciding with the pass band by the first converting unit to the second frequency band.

In addition, according to an embodiment of the present invention, there is provided a control method of a signal processing device. The signal processing device includes a first converting unit for frequency-converting an input signal into a signal in a first frequency band, a filter for cutting off a frequency component outside a predetermined pass band, the frequency component being included in the signal in the first frequency band which signal is frequency-converted by the first converting unit, a second converting unit for frequency-converting the signal whose frequency component outside the pass band is cut off by the filter from the first frequency band to a second frequency band, a third converting unit for converting the signal in the second frequency band which signal is frequency-converted by the second converting unit into a signal in a third frequency band coinciding with the pass band, an oscillating unit for oscillating a signal used for frequency conversion of the third converting unit, and a detecting unit for detecting a frequency error between oscillation frequency of the signal oscillated by the oscillating unit and frequency of a signal used for frequency conversion from the second frequency band to the third frequency band coinciding with the pass band, and outputting an error signal indicating the frequency error. The control method includes the steps of: the oscillating unit being controlled in oscillation frequency according to the error signal output by the detecting unit, and oscillating the signal used to frequency-convert the second frequency band to the third frequency band coinciding with the pass band; the first converting unit being controlled according to the error signal output from the detecting unit, and frequency-converting the input signal into the signal in the first frequency band coinciding with the pass band; and the second converting unit being controlled according to the error signal output from the detecting unit and delayed by a delay time taken by processing of the filter, and frequency-converting the signal whose frequency component outside the pass band is cut off by the filter from the frequency band coinciding with the pass band by the first converting unit to the second frequency band.

According to an embodiment of the present invention, there is provided a digital broadcast receiving device including: a receiving unit for receiving a quadrature-modulated digital broadcast wave; an intermediate frequency converting unit for converting a signal received by the receiving unit into an intermediate frequency band; a quadrature demodulating unit for quadrature-demodulating the signal in the intermediate frequency band which signal is frequency-converted by the intermediate frequency converting unit; a first converting unit for frequency-converting the signal quadrature-demodulated by the quadrature demodulating unit into a signal in a first frequency band; and a filter for cutting off a frequency component in a frequency band higher than a baseband, the frequency component being included in the signal in the first frequency band which signal is frequency-converted by the first converting unit. The digital broadcast receiving device further includes: a second converting unit for frequency-converting the signal whose frequency component in the frequency band higher than the baseband is cut off by the filter into a signal in a second frequency band coinciding with the frequency band frequency-converted by the quadrature demodulating unit; a third converting unit for converting the signal in the second frequency band which signal is frequency-converted by the second converting unit into a signal in a third frequency band coinciding with the baseband; an oscillating unit for oscillating a signal used for frequency conversion of the third converting unit; and a detecting unit for detecting an error between oscillation frequency of the signal oscillated by the oscillating unit and frequency of a signal used by the third converting unit to frequency-convert the signal in the second frequency band into the signal in the third frequency band coinciding with the baseband, and outputting an error signal indicating the error. The oscillating unit is controlled according to the error signal output by the detecting unit, and oscillates the signal used to frequency-convert the signal in the second frequency band to the signal in the third frequency band coinciding with the baseband. The first converting unit is controlled according to the error signal output from the detecting unit, and frequency-converts the input signal into the signal in the first frequency band coinciding with the baseband. The second converting unit is controlled according to the error signal output from the detecting unit and delayed by a delay time taken by processing of the filter, and frequency-converts the signal whose frequency component in the frequency band higher than the baseband is cut off by the filter from the frequency band coinciding with the baseband to the second frequency band.

In addition, according to an embodiment of the present invention, there is provided a control method of a digital broadcast receiving device. The digital broadcast receiving device includes a receiving unit for receiving a quadrature-modulated digital broadcast wave, an intermediate frequency converting unit for converting a signal received by the receiving unit into an intermediate frequency band, a quadrature demodulating unit for quadrature-demodulating the signal in the intermediate frequency band which signal is frequency-converted by the intermediate frequency converting unit, a first converting unit for frequency-converting the signal quadrature-demodulated by the quadrature demodulating unit into a signal in a first frequency band, and a filter for cutting off a frequency component in a frequency band higher than a baseband, the frequency component being included in the signal in the first frequency band which signal is frequency-converted by the first converting unit. The digital broadcast receiving device further includes a second converting unit for frequency-converting the signal whose frequency component in the frequency band higher than the baseband is cut off by the filter into a signal in a second frequency band coinciding with the frequency band frequency-converted by the quadrature demodulating unit, a third converting unit for converting the signal in the second frequency band which signal is frequency-converted by the second converting unit into a signal in a third frequency band coinciding with the baseband, an oscillating unit for oscillating a signal used for frequency conversion of the third converting unit, and a detecting unit for detecting an error between oscillation frequency of the signal oscillated by the oscillating unit and frequency of a signal used by the third converting unit to frequency-convert the signal in the second frequency band into the signal in the third frequency band coinciding with the baseband, and outputting an error signal indicating the error. The control method includes the steps of: the oscillating unit being controlled according to the error signal output by the detecting unit, and oscillating the signal used to frequency-convert the signal in the second frequency band to the signal in the third frequency band coinciding with the baseband; the first converting unit being controlled according to the error signal output from the detecting unit, and frequency-converting the input signal into the signal in the first frequency band coinciding with the baseband; and the second converting unit being controlled according to the error signal output from the detecting unit and delayed by a delay time taken by processing of the filter, and frequency-converting the signal whose frequency component in the frequency band higher than the baseband is cut off by the filter from the frequency band coinciding with the baseband to the second frequency band.

According to an embodiment of the present invention, a feedback system is formed with detection of the error signal by the detecting unit on the basis of the signal output from the third converting unit and control of the frequency of the signal used in the third converting unit according to the error signal by the oscillating unit in this order. This feedback system does not include a filtering process for cutting off the frequency component outside the pass band. Therefore the frequency band of the signal input to the filter is controlled according to the detected frequency error while a delay taken by feedback control is shortened. It is thus possible to cut off the frequency component outside the pass band accurately by following a shift in frequency band of the input signal.

In addition, according to an embodiment of the present invention, the filter for cutting off the frequency component outside the pass band can be realized by a fixed real number coefficient filter. Therefore an increase in circuit scale can be suppressed as compared with a case where a filter is formed with a variable complex coefficient.

### Brief Description of the Drawings

Embodiments of the invention will now be described with reference to the accompanying drawings, throughout which like parts are referred to by like references, and in which:
FIG. 1 is a block diagram showing a general configuration of a digital broadcast receiving device to which an embodiment of the present invention is applied;
FIG. 2 is a block diagram showing a configuration of a quadrature demodulating unit according to a first embodiment;
FIGS. 3A to 3F are diagrams of assistance in explaining processing by the quadrature demodulating unit according to the first embodiment;
FIG. 4 is a block diagram showing a configuration of a quadrature demodulating unit according to a second embodiment;
FIGS. 5A to 5E are diagrams of assistance in explaining processing by the quadrature demodulating unit according to the second embodiment;
FIG. 6 is a block diagram showing a configuration of a quadrature demodulating unit according to a third embodiment; and
FIGS. 7A to 7E are diagrams of assistance in explaining processing by the quadrature demodulating unit according to the third embodiment.

### Description of the Example Embodiments

An example implementation for carrying out the present invention will hereinafter be described in detail with reference to the drawings.

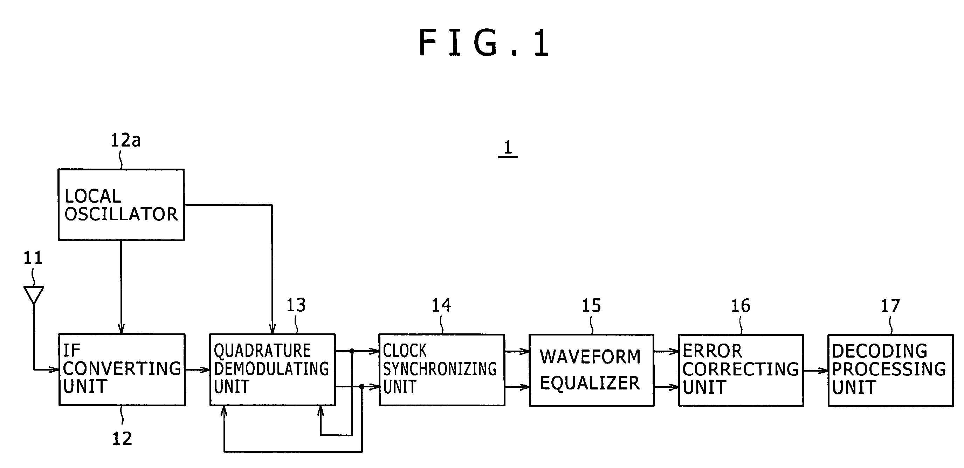

A signal processing device to which an embodiment of the present invention is applied cuts off a predetermined frequency component of an input signal. The signal processing device is incorporated in a digital broadcast receiving device 1 for receiving an RF (Radio Frequency) signal of a single-carrier BS (Broadcasting Satellite) digital broadcast wave of a modulation system, as shown in FIG. 1, for example.

The digital broadcast receiving device 1 includes: an antenna 11 for receiving an RF signal from a transmission line; an IF (Intermediate Frequency) converting unit 12 for converting the RF signal into a signal of an intermediate frequency using a signal oscillated by a local oscillator 12a; a quadrature demodulating unit 13 for frequency-converting the IF signal to a base frequency band (hereinafter referred to as a baseband) and demodulating the IF signal into a baseband signal formed of an I-axis component and a Q-axis component; a clock synchronizing unit 14 for synchronizing the quadrature-demodulated baseband signal with a clock cycle of the digital broadcast signal; a waveform equalizer 15 for performing waveform equalization of the baseband signal; an error correcting unit 16 for subjecting the baseband signal to error correction processing; and a decoding processing unit 17 for subjecting a bit stream to decoding processing.

The antenna 11 receives the RF signal of a BS digital broadcast wave from the transmission line, and then supplies the received RF signal to the IF converting unit 12.

The IF converting unit 12 frequency-converts the RF signal supplied from the antenna 11 into an IF signal using a signal of an IF frequency which signal is oscillated by the local oscillator 12a. The IF converting unit 12 then supplies the IF signal to the quadrature demodulating unit 13. Incidentally, the oscillation frequency of the signal oscillated by the local oscillator 12a needs to coincide accurately with the IF frequency in order to perform a filtering process for cutting off a frequency component of an adjacent channel in a subsequent stage. However, description will be made supposing that the oscillation frequency of the signal oscillated by the local oscillator 12a includes a frequency error, as will be described later.

The quadrature demodulating unit 13 quadrature-demodulates the IF signal supplied from the IF converting unit 12, and frequency-converts the IF signal into a baseband signal formed of an I-axis component and a Q-axis component. The quadrature demodulating unit 13 then supplies the baseband signal formed of the I-axis component and the Q-axis component to the clock synchronizing unit 14. Incidentally, a concrete configuration of the quadrature demodulating unit 13 will be described later.

In order to synchronize the baseband signal supplied from the quadrature demodulating unit 13 with a clock cycle of the digital broadcast signal, the clock synchronizing unit 14 reproduces a transmission clock for synchronizing the baseband signal with one symbol cycle. The clock synchronizing unit 14 then supplies the baseband signal synchronized with the transmission clock to the waveform equalizer 15.

The waveform equalizer 15 equalizes the signal waveform of the baseband signal supplied from the clock synchronizing unit 14. The waveform equalizer 15 then supplies the baseband signal whose waveform is equalized to the error correcting unit 16. Specifically, the waveform equalizer 15 performs the equalizing process in a symbol unit on the basis of the transmission clock reproduced by the clock synchronizing unit 14.

The error correcting unit 16 subjects the baseband signal whose waveform is equalized by the waveform equalizer 15 to error correction processing, converts the baseband signal into a bit stream such, for example, as an MPEG transport stream having video data and audio data multiplexed therein, and then supplies the bit stream to the decoding processing unit 17.

The decoding processing unit 17 decodes video data and audio data from the bit stream supplied from the error correcting unit 16. The video data decoded by the decoding processing unit 17 is subjected to predetermined image processing, and then output to a display or the like.

Description in the following will be made directing attention to the configuration and the operation of the quadrature demodulating unit 13 in the digital broadcast receiving device 1 of the configuration as described above.

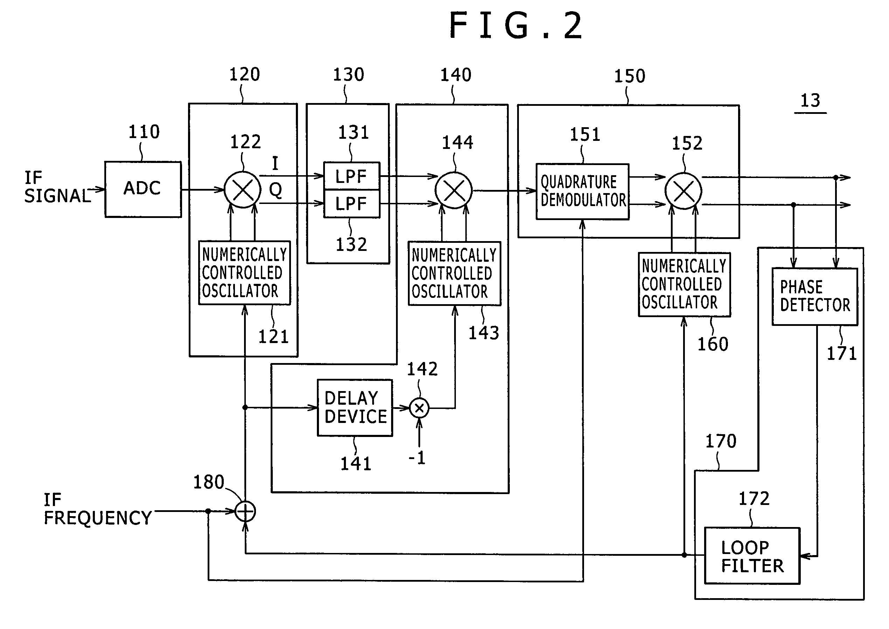

A first embodiment of the quadrature demodulating unit 13 will first be described with reference to FIG. 2.

The quadrature demodulating unit 13 according to the present embodiment is a processing unit for generating a baseband signal formed of an I-axis component and a Q-axis component as described above, and performing a filtering process for cutting off a frequency component of an adjacent channel which frequency component is included in an IF signal. The quadrature demodulating unit 13 includes an A/D converting section 110, a first frequency converting section 120, a filter section 130, a second frequency converting section 140, a third frequency converting section 150, a numerically controlled oscillator 160, a detecting section 170, and an adder 180.

The A/D converting section 110 samples the IF signal supplied from the IF converting unit 12, and thereby converts the IF signal into a digital IF signal. The A/D converting section 110 then supplies the digital IF signal to the first frequency converting section 120.

The first frequency converting section 120 is controlled according to an error signal to be described later to convert the digital IF signal supplied from the A/D converting section 110 into a signal in a first frequency band coinciding with a baseband. Specifically, the first frequency converting section 120 includes a numerically controlled oscillator (NCO) 121 and a quadrature demodulator 122. The numerically controlled oscillator 121 and the quadrature demodulator 122 in the first frequency converting section 120 operate as follows to output a signal in the first frequency band coinciding with the pass band of the filter section 130 according to the error signal indicating a frequency error to which the IF frequency to be described later is added.

The numerically controlled oscillator 121 oscillates a signal while controlling the oscillation frequency of the signal according to the error signal supplied from the adder 180 to be described later. The numerically controlled oscillator 121 then outputs the oscillated signal to the quadrature demodulator 122.

The quadrature demodulator 122 quadrature-demodulates the IF signal in an intermediate frequency band using the signal oscillated by the numerically controlled oscillator 121, and frequency-converts the IF signal into a signal in the first frequency band coinciding with the pass band of the filter section 130.

Specifically, the quadrature demodulator 122 combines each of the signal oscillated by the numerically controlled oscillator 121 and a signal obtained by shifting the phase of the oscillated signal by 90 degrees with the IF signal supplied from the A/D converting section 110, thereby generates a signal in the first frequency band which signal is formed of an I-axis component and a Q-axis component, and then supplies the signal in the first frequency band to the filter section 130.

For the signal in the first frequency band which signal is output from the first frequency converting section 120, the filter section 130 sets the baseband as a pass band thereof to cut off a signal component of an adjacent channel, and cuts off the frequency component outside the pass band, that is, in a frequency band higher than the baseband. The filter section 130 then supplies the result to the second frequency converting section 140. Specifically, the filter unit 130 includes a low-pass filter 131 for subjecting the I-axis component of the signal in the first frequency band to a filter process, and a low-pass filter 132 for subjecting the Q-axis component of the signal in the first frequency band to a filter process.

The second frequency converting section 140 is controlled according to the error signal to frequency-convert the signal that is supplied from the filter section 130 and whose frequency component outside the pass band is cut off from the first frequency band to a second frequency band. The second frequency converting section 140 then supplies a resulting signal to the third frequency converting section 150.

Specifically, the second frequency converting section 140 is a processing unit for frequency-converting the signal whose frequency component outside the pass band is cut off by the filter section 130 from the first frequency band controlled to coincide with the pass band by the first frequency converting section 120 to the second frequency band according to the error signal supplied from the adder 180. The second frequency converting section 140 includes a delay device 141, a multiplier 142, a numerically controlled oscillator 143, and a quadrature modulator 144.

The delay device 141 delays the error signal supplied from the adder 180 by a delay time taken by the processing of the filter section 130, and then supplies the error signal to the multiplier 142. The error signal is thus delayed because the frequency band of the signal input to the second frequency converting section 140 is the first frequency band obtained by frequency conversion by the first frequency converting section 120 according to the error signal preceding by the delay time.

The multiplier 142 multiplies the value of a frequency indicated by the error signal supplied from the delay device 141 by (-1) to perform frequency conversion from the first frequency band to the intermediate frequency band. The multiplier 142 then supplies the error signal indicating the frequency resulting from the multiplication process to the numerically controlled oscillator 143.

The numerically controlled oscillator 143 oscillates a signal whose frequency is controlled according to the error signal supplied from the multiplier 142. The numerically controlled oscillator 143 then supplies the oscillated signal to the quadrature modulator 144.

Using the signal oscillated by the numerically controlled oscillator 143, the quadrature modulator 144 quadrature-modulates the signal whose frequency component outside the pass band is cut off by the filter section 130 into a signal in the second frequency band coinciding with the intermediate frequency band. The quadrature modulator 144 then supplies the quadrature-modulated signal to the third frequency converting section 150.

The third frequency converting section 150 includes a quadrature demodulator 151 and a frequency converter 152 to convert the signal in the second frequency band which signal is frequency-converted by the second frequency converting section 140 into a signal in a third frequency band coinciding with the pass band of the above-described filter section 130.

The quadrature demodulator 151 quadrature-demodulates the signal in the intermediate frequency band which signal is quadrature-modulated by the second frequency converting section 140. The quadrature demodulator 151 then supplies the quadrature-demodulated signal to the frequency converter 152.

The frequency converter 152 frequency-converts the signal quadrature-demodulated by the quadrature demodulator 151 into a signal in a third frequency band coinciding with the pass band of the filter section 130, using a signal oscillated by the numerically controlled oscillator 160 to be described later. The frequency converter 152 then supplies the signal in the third frequency band to the detecting section 170 and the clock synchronizing unit 14.

The numerically controlled oscillator 160 oscillates the signal used for the frequency conversion of the third frequency converting section 150. Specifically, the numerically controlled oscillator 160 is controlled according to the error signal output by the detecting section 170 to oscillate the signal used for frequency conversion of the second frequency band to the third frequency band coinciding with the pass band.

The detecting section 170 detects an error between the oscillation frequency of the signal oscillated by the numerically controlled oscillator 160 and the frequency of a signal used for frequency conversion from the second frequency band to the third frequency band coinciding with the pass band of the filter section 130. The detecting section 170 outputs the error signal indicating this frequency error.

Specifically, the detecting section 170 includes a phase error detector 171 and a loop filter 172 to detect the frequency error and output the error signal.

The phase error detector 171 detects a phase error between a signal point indicated by the signal in the third frequency band which signal is frequency-converted by the third frequency converting section 150 and a signal point transmitted by the digital broadcast signal. The phase error detector 171 then supplies a result of the detection to the loop filter 172.

The loop filter 172 filters the result of the detection by the phase error detector 171, and then outputs the error signal.

The adder 180 adds the IF frequency to the frequency error indicated by the error signal output from the detecting section 170. The adder 180 then supplies the error signal resulting from the addition process to the first frequency converting section 120 and the second frequency converting section 140. This is because each of the first frequency converting section 120 and the second frequency converting section 140 performing frequency band conversion between the intermediate frequency band and the baseband needs information on the oscillation frequency of the local oscillator 12a used to convert the RF signal into the intermediate frequency band, that is, the IF frequency.

By performing processing as shown in FIG. 2, for example, even when the center frequency of the IF signal supplied from the IF converting unit 12 is shifted from the IF frequency, the quadrature demodulating unit 13 according to the first embodiment formed by the configuration as described above can perform control to make the frequency band of the signal input to the filter section 130 coincide with the baseband according to the frequency error detected in the detecting section 170. Thereby, the quadrature demodulating unit 13 can cut off the frequency component outside the pass band accurately by following a shift in frequency band of the IF signal as an input signal from the IF converting unit 12.

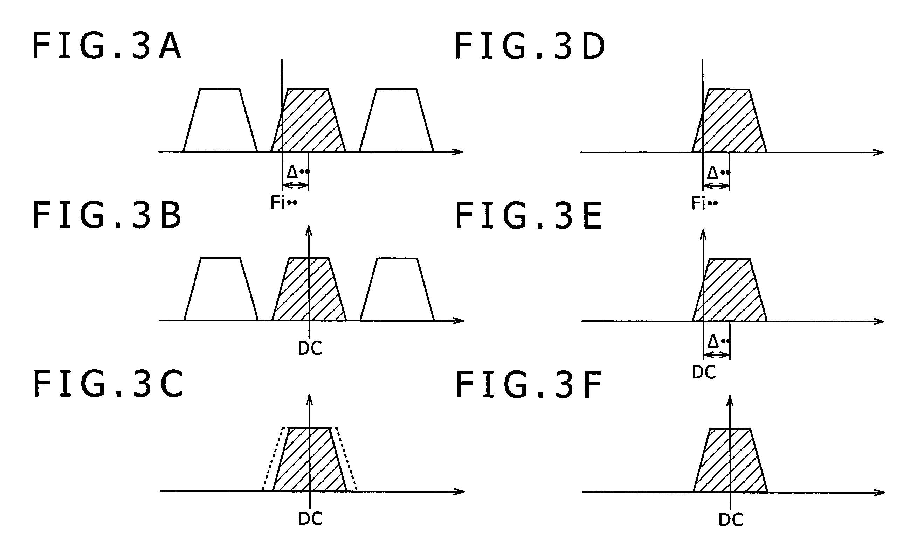

First, the quadrature demodulating unit 13 according to the first embodiment is supplied with the IF signal from the IF converting unit 12. In this case, the IF frequency is Fif. However, suppose that as shown in FIG. 3A, the center frequency of the IF signal supplied to the quadrature demodulating unit 13 is Fif + Δf due to an oscillation error of the local oscillator 12a. Incidentally, a band indicated by oblique lines in FIGS. 3A to 3F is a frequency band including a signal component of a desired received channel.

The detecting section 170 in the quadrature demodulating unit 13 detects the frequency error Δf, and outputs an error signal indicating the frequency error Δf, whereby the following process is realized.

In the first frequency converting section 120 of the quadrature demodulating unit 13, the numerically controlled oscillator 121 oscillates a signal having an oscillation frequency of -(Fif + Δf) according to the error signal. As shown in FIG. 3B, the quadrature demodulator 122 frequency-converts the IF signal into the first frequency band coinciding with the baseband using the oscillated signal.

Next, the filter section 130 cuts off a frequency component outside the pass band shown in FIG. 3C which frequency component is included in the signal frequency-converted by the first frequency converting section 120 such that the first frequency band of the signal coincides with the baseband.

Next, in the second frequency converting section 140, the numerically controlled oscillator 143 oscillates a signal having an oscillation frequency of Fif + Δf according to the error signal. As shown in FIG. 3D, the quadrature modulator 144 frequency-converts the signal whose frequency component outside the pass band is cut off into the second frequency band coinciding with the intermediate frequency band of the IF signal using the oscillated signal.

Next, the quadrature demodulator 151 of the third frequency converting section 150 oscillates a signal of - Fif, which is the IF frequency of the IF signal. Using this signal, as shown in FIG. 3E, the quadrature demodulator 151 quadrature-demodulates the signal frequency-converted by the quadrature modulator 144 into a signal in a frequency band shifted by Δf with respect to the baseband.

Next, the numerically controlled oscillator 160 oscillates a signal having an oscillation frequency of - Δf according to the error signal. Using the oscillated signal, as shown in FIG. 3F, the third frequency converting section 150 frequency-converts the signal quadrature-demodulated by the quadrature demodulator 151 into the third frequency band coinciding with the baseband.

Thus, in the quadrature demodulating unit 13 according to the first embodiment, a feedback control system is formed with detection of the error signal by the detecting section 170 on the basis of the signal output from the third frequency converting section 150 and control of the frequency of the signal used in the third frequency converting section 150 according to the error signal by the numerically controlled oscillator 160 in this order. This feedback system does not include the filtering process of the filter section 130 for cutting off the frequency component outside the pass band. Therefore control can be performed so as to make the frequency band of the signal input to the filter section 130 coincide with the pass band according to the detected frequency error while shortening a delay taken by feedback control. Thus, the quadrature demodulating unit 13 can supply the signal whose frequency component outside the pass band is cut off accurately by following a shift in frequency band of the IF signal to the clock synchronizing unit 14 in a subsequent stage.

In addition, in the quadrature demodulating unit 13 according to the first embodiment, the filter section 130 for cutting off the frequency component outside the pass band can be realized by a fixed real number coefficient filter. Therefore an increase in circuit scale can be suppressed as compared with a case where a filter is formed with a variable complex coefficient.

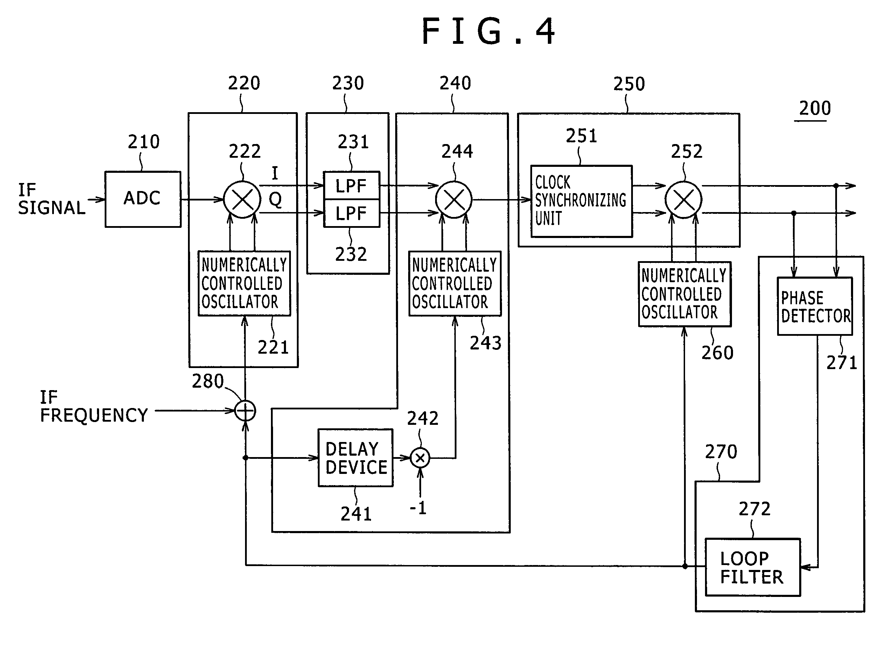

A quadrature demodulating unit 200 according to a second embodiment will next be described with reference to FIG. 4. This quadrature demodulating unit 200 is a processing unit for performing a process of the above-described clock synchronizing unit 14, and cutting off a frequency component of an adjacent channel and performing quadrature demodulation.

Specifically, as shown in FIG. 4, the quadrature demodulating unit 200 according to the second embodiment includes an A/D converting unit 210, a first frequency converting unit 220, a filter unit 230, a second frequency converting unit 240, a third frequency converting unit 250, a numerically controlled oscillator 260, a detecting unit 270, and an adder 280.

The A/D converting unit 210 samples the IF signal supplied from the IF converting unit 12, and thereby converts the IF signal into a digital IF signal. The A/D converting unit 210 then supplies the digital IF signal to the first frequency converting unit 220.

The first frequency converting unit 220 is a processing unit controlled according to an error signal to convert the digital IF signal supplied from the A/D converting unit 210 into a signal in a first frequency band. The first frequency converting unit 220 includes a numerically controlled oscillator 221 and a quadrature demodulator 222. The numerically controlled oscillator 221 and the quadrature demodulator 222 in the first frequency converting unit 220 operate as follows to output the signal in the first frequency band coinciding with the pass band of the filter unit 230 according to the error signal to which the IF frequency supplied from the adder 280 to be described later is added.

The numerically controlled oscillator 221 oscillates a signal while controlling the oscillation frequency of the signal according to the error signal that is output from the detecting unit 270 and which results from an addition process by the adder 280. The numerically controlled oscillator 221 then outputs the oscillated signal to the quadrature demodulator 222.

The quadrature demodulator 222 quadrature-demodulates the IF signal in an intermediate frequency band using the signal oscillated by the numerically controlled oscillator 221, and frequency-converts the IF signal into a signal in the first frequency band coinciding with the pass band of filters.

Specifically, the quadrature demodulator 222 combines each of the signal oscillated by the numerically controlled oscillator 221 and a signal obtained by shifting the phase of the oscillated signal by 90 degrees with the IF signal supplied from the A/D converting unit 210, thereby generates a signal in the first frequency band which signal is formed of an I-axis component and a Q-axis component, and then supplies the signal in the first frequency band to the filter unit 230.

For the signal in the first frequency band which signal is supplied from the first frequency converting unit 220, the filter unit 230 sets a baseband as a pass band thereof to cut off a signal component of an adjacent channel, and cuts off the frequency component outside the pass band, that is, the frequency component in a frequency band higher than the baseband. The filter unit 230 then supplies the result to the second frequency converting unit 240. Specifically, the filter unit 230 includes a low-pass filter 231 for subjecting the I-axis component of the first baseband signal to a filter process, and a low-pass filter 232 for subjecting the Q-axis component of the first baseband signal to a filter process.

The second frequency converting unit 240 frequency-converts the signal that is supplied from the filter unit 230 and whose frequency component outside the pass band is cut off from the first frequency band to a second frequency band. The second frequency converting unit 240 then supplies a resulting signal to the third frequency converting unit 250. Specifically, the second frequency converting unit 240 is controlled according to the error signal delayed by a delay time taken by the filter processing of the filter unit 230. In order to frequency-convert the signal whose frequency component outside the pass band is cut off by the filter unit 230 from the first baseband controlled to coincide with the pass band by the first frequency converting unit 220 to the second frequency band, the second frequency converting unit 240 includes a delay device 241, a multiplier 242, a numerically controlled oscillator 243, and a frequency converter 244.

The delay device 241 delays the error signal output from the detecting unit 270 by the delay time taken by the processing of the filter unit 230, and then supplies the error signal to the multiplier 242. The error signal is thus delayed because the frequency band of the signal input to the second frequency converting unit 240 is the first frequency band obtained by frequency conversion by the first frequency converting unit 220 according to the error signal preceding by the delay time.

The multiplier 242 multiplies the value of a frequency indicated by the error signal supplied from the delay device 241 by (-1) to perform frequency conversion to a frequency band higher than the first frequency band by an error frequency indicated by the error signal. The multiplier 242 then supplies the error signal indicating the frequency resulting from the multiplication process to the numerically controlled oscillator 243.

The numerically controlled oscillator 243 oscillates a signal whose frequency is controlled according to the error signal supplied from the multiplier 242. The numerically controlled oscillator 243 then supplies the oscillated signal to the frequency converter 244.

Using the signal oscillated by the numerically controlled oscillator 243, the frequency converter 244 frequency-converts the signal whose frequency component outside the pass band is cut off by the filter unit 230 into a signal in the second frequency band coinciding with the frequency band higher than the first frequency band by the error frequency indicated by the error signal. The frequency converter 244 then supplies the signal in the second frequency band to the third frequency converting unit 250.

The third frequency converting unit 250 includes a clock synchronizing unit 251 and a frequency converter 252 to convert the signal in the second frequency band which signal is frequency-converted by the second frequency converting unit 240 into a signal in a frequency band coinciding with the pass band of the above-described filter unit 230, and achieve synchronization with the above-described transmission clock.

In order to synchronize the signal in the second frequency band which signal is supplied from the second frequency converting unit 240 with a clock cycle of the digital broadcast signal, the clock synchronizing unit 251 reproduces the transmission clock for synchronizing the signal with one symbol cycle. The clock synchronizing unit 251 then supplies the signal synchronized with the transmission clock to the frequency converter 252.

The frequency converter 252 frequency-converts the signal synchronized with the transmission clock by the clock synchronizing unit 251 into a signal in a third frequency band coinciding with the pass band of the filter unit 230, using a signal oscillated by the numerically controlled oscillator 260 to be described later. The frequency converter 252 then supplies the signal in the third frequency band to the detecting unit 270 and the waveform equalizer 15.

The numerically controlled oscillator 260 oscillates the signal used for the frequency conversion of the third frequency converting unit 250. Specifically, the numerically controlled oscillator 260 is controlled according to the error signal output by the detecting unit 270 to oscillate the signal used for frequency conversion of the second frequency band to the frequency band coinciding with the pass band.

The detecting unit 270 detects a frequency error between the oscillation frequency of the signal oscillated by the numerically controlled oscillator 260 and the frequency of a signal used for frequency conversion from the second frequency band to the frequency band coinciding with the pass band of the filter unit 230. The detecting unit 270 outputs the error signal indicating this frequency error.

Specifically, the detecting unit 270 includes a phase error detector 271 and a loop filter 272 to detect the frequency error and output the error signal.

The phase error detector 271 detects a phase error between a signal point indicated by the signal in the third frequency band which signal is frequency-converted by the third frequency converting unit 250 and a signal point transmitted by the digital broadcast signal. The phase error detector 271 then supplies a result of the detection to the loop filter 272.

The loop filter 272 filters the result of the detection by the phase error detector 271, and then outputs the error signal.

The adder 280 adds the IF frequency to the frequency error indicated by the error signal output from the detecting unit 270. The adder 280 then supplies the error signal resulting from the addition process to the first frequency converting unit 220. Such addition of the adder 280 is performed because the first frequency converting unit 220 performing frequency band conversion between the intermediate frequency band and the baseband needs the IF frequency used to convert the RF signal into the intermediate frequency band.

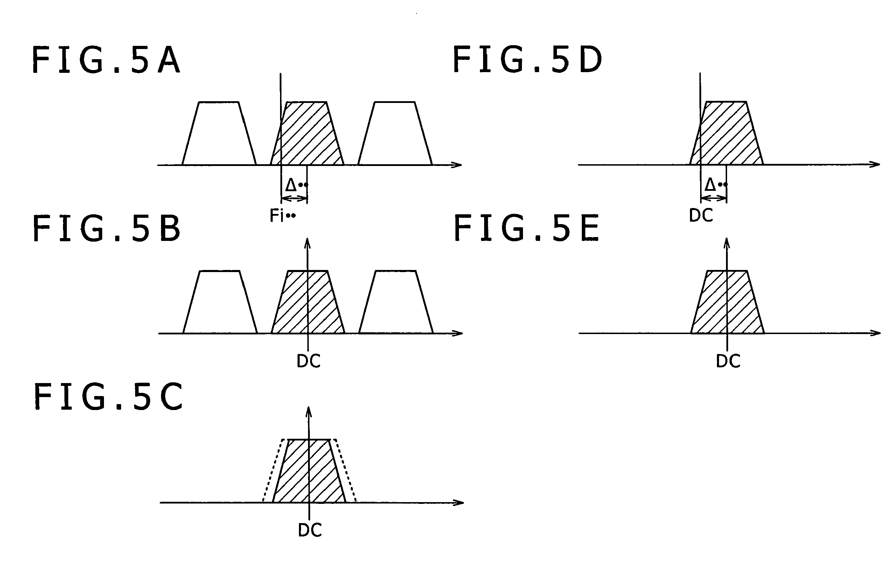

By performing processing as shown in FIGS. 5A to 5E, even when the center frequency of the IF signal supplied from the IF converting unit 12 is shifted from the IF frequency, the quadrature demodulating unit 200 according to the second embodiment formed by the configuration as described above performs control to make the frequency band of the signal input to the filter unit 230 coincide with the baseband according to the frequency error detected in the detecting unit 270. Thus, the quadrature demodulating unit 200 can cut off the frequency component outside the pass band accurately by following a shift in frequency band of the IF signal, and output a baseband signal synchronized with the transmission clock.

First, the quadrature demodulating unit 200 according to the second embodiment is supplied with the IF signal as shown in FIG. 5A from the IF converting unit 12. In this case, as shown in FIG. 5A, the IF frequency, which is the center frequency of the IF signal, is Fif. However, suppose that the center frequency of the IF signal output from the IF converting unit 12 is Fif + Δf due to an oscillation error of the local oscillator 12a. Incidentally, a band indicated by oblique lines in FIGS. 5A to 5E is a frequency band including a signal component of a desired received channel. The detecting unit 270 in the quadrature demodulating unit 200 detects the frequency error Δf, and outputs an error signal indicating the frequency error Δf, whereby the following process is realized.

In the quadrature demodulating unit 200 supplied with the IF signal including such a frequency error Δf, the numerically controlled oscillator 221 in the first frequency converting unit 220 oscillates a signal having an oscillation frequency of -(Fif + Δf) according to information indicated by the error signal. As shown in FIG. 5B, the quadrature demodulator 222 frequency-converts the IF signal into the first frequency band coinciding with the pass band of the filter unit 230.

Next, the filter unit 230 in the quadrature demodulating unit 200 cuts off a frequency component outside the pass band which frequency component is shown by dotted lines in FIG. 5C and is included in the signal in the first frequency band frequency-converted by the first frequency converting unit 220 so as to coincide with the pass band.

Next, in the quadrature demodulating unit 200, the numerically controlled oscillator 243 of the second frequency converting unit 240 oscillates a signal having an oscillation frequency of Δf according to the information indicated by the error signal. As shown in FIG. 5D, using this signal, the frequency converter 244 frequency-converts the signal whose frequency component outside the pass band is cut off into a signal in the second frequency band coinciding with the frequency band higher than the baseband by Δf.

Next, the numerically controlled oscillator 260 oscillates a signal having an oscillation frequency of - Δf according to the error signal. Using the oscillated signal, as shown in FIG. 5E, the third frequency converting unit 250 frequency-converts the signal frequency-converted by the frequency converter 244 into the third frequency band coinciding with the baseband.

Thus, in the quadrature demodulating unit 200 according to the second embodiment, a feedback control system is formed with detection of the error signal by the detecting unit 270 on the basis of the signal output from the third frequency converting unit 250 and control of the frequency of the signal used in the third frequency converting unit 250 according to the error signal by the numerically controlled oscillator 260 in this order. This feedback system does not include the filtering process of the filter unit 230 for cutting off the frequency component outside the pass band. Therefore control can be performed so as to make the frequency band of the signal input to the filter unit 230 coincide with the pass band according to the detected frequency error while shortening a delay taken by feedback control. Thus, the quadrature demodulating unit 200 can cut off the frequency component outside the pass band accurately by following a shift in frequency band of the IF signal, and output the baseband signal synchronized with the transmission clock.

In addition, in the quadrature demodulating unit 200 according to the second embodiment, the filter unit 230 for cutting off the frequency component outside the pass band can be realized by a fixed real number coefficient filter. Therefore an increase in circuit scale can be suppressed as compared with a case where a filter is formed with a variable complex coefficient.

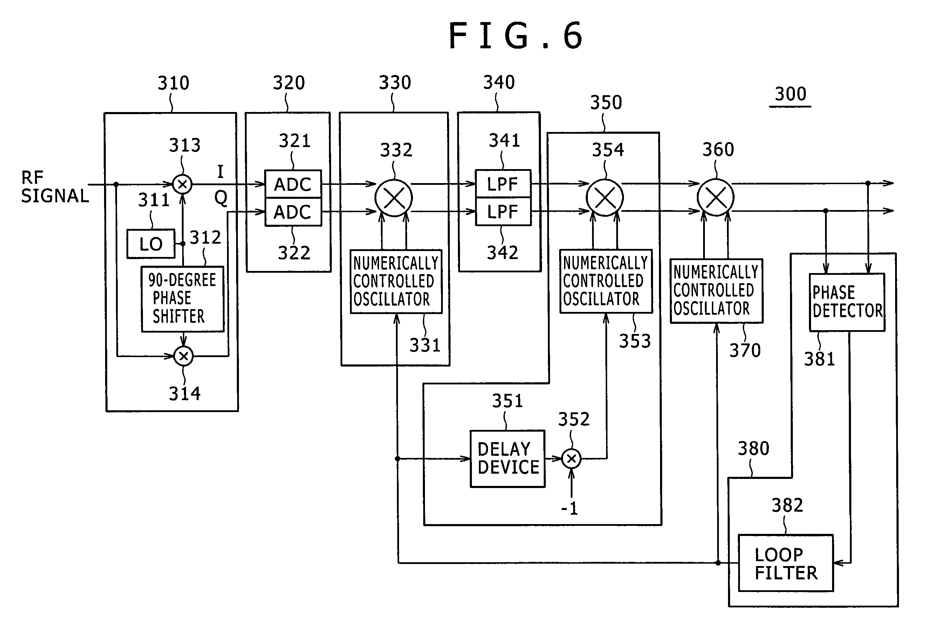

A quadrature demodulating unit 300 according to a third embodiment will next be described with reference to FIG. 6. This quadrature demodulating unit 300 includes a quadrature demodulator 310 as well as an A/D converting unit 320, a first frequency converting unit 330, a filter unit 340, a second frequency converting unit 350, a third frequency converting unit 360, a numerically controlled oscillator 370, and a detecting unit 380 as a processing unit for performing quadrature detection of a signal resulting from quadrature conversion by the quadrature demodulator 310.

The quadrature demodulator 310 includes a local oscillator (LO) 311, a 90-degree phase shifter 312, and frequency converters 313 and 314 to subject the RF signal supplied from the antenna 11 to quadrature demodulation and convert the RF signal into a baseband signal formed of an I-axis component and a Q-axis component.

The local oscillator 311 oscillates a signal for frequency-converting an IF signal into a baseband signal. The local oscillator 311 supplies the oscillated signal to the 90-degree phase shifter 312 and the frequency converter 313.

The 90-degree phase shifter 312 shifts the phase of the signal oscillated by the local oscillator 311 by 90 degrees. The 90-degree phase shifter 312 supplies the signal to the frequency converter 314.

The frequency converter 313 combines the IF signal with the signal oscillated by the local oscillator 311, and then outputs a baseband signal of an I-axis component.

The frequency converter 314 combines the IF signal with the signal output by the 90-degree phase shifter 312, and then outputs a baseband signal of a Q-axis component.

The A/D converting unit 320 samples the baseband signals supplied from the quadrature demodulator 310, and thereby converts the baseband signals into a digital baseband signal. Specifically, the A/D converting unit 320 includes: an A/D converter 321 for converting the I-axis component into a digital signal; and an A/D converter 322 for converting the Q-axis component into a digital signal. The A/D converting unit 320 supplies the baseband signal formed of the I-axis component and the Q-axis component converted into the digital signals by the A/D converters 321 and 322 to the first frequency converting unit 330. Incidentally, suppose that the baseband signals output from the quadrature demodulator 310 are frequency-converted into a frequency band that does not precisely coincide with the pass band of the filter unit 340 due to an oscillation error of the local oscillator 12a of the IF converting unit 12 and the local oscillator 311.

The first frequency converting unit 330 is a processing unit for converting the baseband signal supplied from the A/D converting unit 320 into a signal in a first frequency band. The first frequency converting unit 330 includes a numerically controlled oscillator 331 and a frequency converter 332. The numerically controlled oscillator 331 and the frequency converter 332 in the first frequency converting unit 330 operate as follows to output the signal in the first frequency band coinciding with the pass band of the filter unit 340 according to the error signal supplied from the detecting unit 380.

The numerically controlled oscillator 331 oscillates a signal while controlling the oscillation frequency of the signal according to the error signal output from the detecting unit 380. The numerically controlled oscillator 331 then outputs the oscillated signal to the frequency converter 332.

The frequency converter 332 frequency-converts the baseband signals demodulated by the quadrature demodulator 310 into a signal in the first frequency band coinciding with the pass band of the filter unit 340 using the signal oscillated by the numerically controlled oscillator 331.

For the signal in the first frequency band which signal is output from the first frequency converting unit 330, the filter unit 340 sets the baseband as a pass band thereof to cut off a signal component of an adjacent channel, and cuts off the frequency component outside the pass band. The filter unit 340 then supplies the result to the second frequency converting unit 350. Specifically, the filter unit 340 includes a low-pass filter 341 for subjecting the I-axis component of the signal in the first frequency band to a filter process, and a low-pass filter 342 for subjecting the Q-axis component of the signal in the first frequency band to a filter process.

The second frequency converting unit 350 frequency-converts the signal which is supplied from the filter unit 340 and whose frequency component outside the pass band is cut off from the first frequency band to a second frequency band, that is, a frequency band higher than the baseband by an error frequency indicated by the error signal. The second frequency converting unit 350 then supplies the signal to the third frequency converting unit 360. Specifically, the second frequency converting unit 350 is controlled according to the error signal delayed by a delay time taken by the filter processing of the filter unit 340. In order to frequency-convert the signal whose frequency component outside the pass band is cut off by the filter unit 340 from the first frequency band controlled to coincide with the pass band by the first frequency converting unit 330 to the second frequency band, the second frequency converting unit 350 includes a delay device 351, a multiplier 352, a numerically controlled oscillator 353, and a frequency converter 354.

The delay device 351 delays the error signal output from the detecting unit 380 by the delay time taken by the processing of the filter unit 340, and then supplies the error signal to the multiplier 352.

The multiplier 352 multiplies the value of the frequency indicated by the error signal supplied from the delay device 351 by (-1) to perform frequency conversion to the frequency band higher than the first frequency band by the error frequency indicated by the error signal. The multiplier 352 then supplies the error signal indicating the frequency resulting from the multiplication process to the numerically controlled oscillator 353.

The numerically controlled oscillator 353 oscillates a signal whose frequency is controlled according to the error signal supplied from the multiplier 352. The numerically controlled oscillator 353 then supplies the oscillated signal to the frequency converter 354.

Using the signal oscillated by the numerically controlled oscillator 353, the frequency converter 354 frequency-converts the signal whose frequency component outside the pass band is cut off by the filter unit 340 into a signal in the second frequency band coinciding with the frequency band higher than the first frequency band by the error frequency indicated by the error signal. The frequency converter 354 then supplies the signal in the second frequency band to the third frequency converting unit 360.

The third frequency converting unit 360 converts the signal in the second frequency band which signal is frequency-converted by the second frequency converting unit 350 into a signal in a frequency band coinciding with the pass band of the above-described filter unit 340.

Specifically, the third frequency converting unit 360 frequency-converts the signal in the second frequency band which signal is frequency-converted by the second frequency converting unit 350 into a signal in the third frequency band coinciding with the pass band of the filter unit 340, using a signal oscillated by the numerically controlled oscillator 370 to be described later. The third frequency converting unit 360 then supplies the signal in the third frequency band to the detecting unit 380 and the clock synchronizing unit 14.

The numerically controlled oscillator 370 oscillates the signal used for the frequency conversion of the third frequency converting unit 360. Specifically, the numerically controlled oscillator 370 is controlled according to the error signal output by the detecting unit 380 to oscillate the signal used for frequency conversion of the second frequency band to the frequency band coinciding with the pass band.

The detecting unit 380 detects an error between the oscillation frequency of the signal oscillated by the numerically controlled oscillator 370 and the frequency of a signal used for frequency conversion from the second frequency band to the frequency band coinciding with the pass band of the filter unit 340. The detecting unit 270 outputs the error signal indicating this error.

Specifically, the detecting unit 380 includes a phase error detector 381 and a loop filter 382 to detect the frequency error and output the error signal.

The phase error detector 381 detects a phase error between a signal point indicated by the signal in the third frequency band which signal is frequency-converted by the third frequency converting unit 360 and a signal point transmitted by the digital broadcast signal. The phase error detector 381 then supplies a result of the detection to the loop filter 382.

The loop filter 382 filters the result of the detection by the phase error detector 381, and then outputs the error signal.

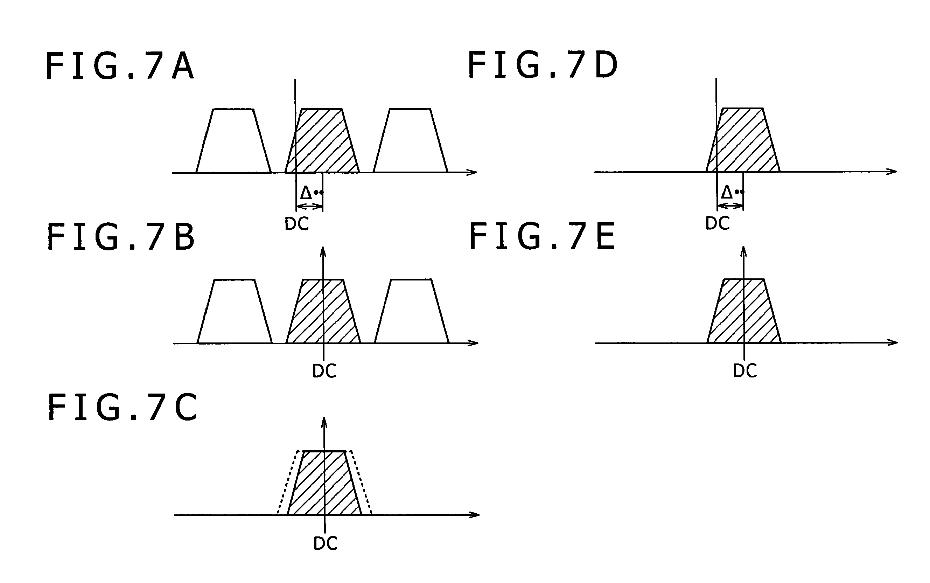

By performing processing as shown in FIGS. 7A to 7E, even when the frequency band of the baseband signal demodulated by the quadrature demodulator 310 is shifted from the pass band of the filter unit 340, the quadrature demodulating unit 300 according to the third embodiment formed by the configuration as described above performs control to make the frequency band of the signal input to the filter unit 340 coincide with the pass band according to the frequency error detected in the detecting unit 380. Thus, the quadrature demodulating unit 300 can cut off the frequency component outside the pass band accurately by following a shift in frequency band of the baseband signal frequency-converted by the quadrature demodulator 310.

First, in the quadrature demodulating unit 300 according to the third embodiment, a baseband signal including a frequency error as shown in FIG. 7A is supplied to the first frequency converting unit 330. In this case, as shown in FIG. 7A, the band of the baseband signal is shifted by the frequency error Δf. Incidentally, a band indicated by oblique lines in FIGS. 7A to 7E is a frequency band including a signal component of a desired received channel.

The detecting unit 380 in the quadrature demodulating unit 300 detects the frequency error Δf, and outputs an error signal indicating the frequency error Δf, whereby the following process is realized.

In the first frequency converting unit 330 supplied with such a baseband signal whose band is shifted by the frequency error Δf, the numerically controlled oscillator 331 oscillates a signal having an oscillation frequency of -Δf according to information indicated by the error signal. Using the oscillated signal, the frequency converter 332 frequency-converts the baseband signal into the first frequency band coinciding with the pass band of the filter unit 340.

Next, the filter unit 340 cuts off a frequency component outside the pass band which frequency component is shown by dotted lines in FIG. 7C and is included in the signal in the first frequency band frequency-converted by the first frequency converting unit 330 so as to coincide with the baseband.

Next, the numerically controlled oscillator 353 of the second frequency converting unit 350 oscillates a signal having an oscillation frequency of Δf according to the information indicated by the error signal. As shown in FIG. 7D, using this signal, the frequency converter 354 frequency-converts the signal whose frequency component outside the pass band is cut off into a signal in the second frequency band coinciding with the frequency band higher than the baseband by Δf.

Next, the numerically controlled oscillator 370 oscillates a signal having an oscillation frequency of - Δf according to the error signal. Using the oscillated signal, as shown in FIG. 7E, the third frequency converting unit 360 frequency-converts the signal frequency-converted by the frequency converter 354 into the third frequency band coinciding with the baseband.

Thus, in the quadrature demodulating unit 300 according to the third embodiment, a feedback system is formed with detection of the error signal by the detecting unit 380 on the basis of the signal output from the third frequency converting unit 360 and control of the frequency of the signal used in the third frequency converting unit 360 according to the error signal by the numerically controlled oscillator 370 in this order. This feedback system does not include the filtering process of the filter unit 340 for cutting off the frequency component outside the pass band. Therefore control can be performed so as to make the frequency band of the signal input to the filter unit 340 coincide with the pass band according to the detected frequency error while shortening a delay taken by feedback control. Thus, the quadrature demodulating unit 300 can cut off the frequency component outside the pass band accurately by following a shift in frequency band of the baseband signal quadrature-demodulated by the quadrature demodulator 310.

In addition, in the quadrature demodulating unit 300 according to the third embodiment, the filter unit 340 for cutting off the frequency component outside the pass band can be realized by a fixed real number coefficient filter. Therefore an increase in circuit scale can be suppressed as compared with a case where a filter is formed with a variable complex coefficient.

It is to be noted that the present invention is not limited to the above embodiments, and that various changes can of course be made without departing from the present invention as defined by the claims.

It should be understood by those skilled in the art that various modifications, combinations, subcombinations and alterations may occur depending on design requirements and other factors insofar as they are within the scope of the appended claims.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

## Claims

1. A signal processing device for cutting off a predetermined frequency component of an input signal, said signal processing device comprising:
first converting means for frequency-converting said input signal into a signal in a first frequency band;
a filter for cutting off the frequency component outside a predetermined pass band, the frequency component being included in the signal in the first frequency band which signal is frequency-converted by said first converting means;
second converting means for frequency-converting the signal whose frequency component outside the pass band is cut off by said filter from said first frequency band to a second frequency band;
third converting means for converting the signal in the second frequency band which signal is frequency-converted by said second converting means into a signal in a third frequency band coinciding with said pass band;
oscillating means for oscillating a signal used for frequency conversion of said third converting means; and
detecting means for detecting a frequency error between oscillation frequency of the signal oscillated by said oscillating means and frequency of a signal used for frequency conversion from said second frequency band to said third frequency band coinciding with said pass band, and outputting an error signal indicating said frequency error;
wherein oscillation frequency of said oscillating means is controlled according to the error signal output by said detecting means, and said oscillating means oscillates the signal used to frequency-convert said second frequency band to the third frequency band coinciding with said pass band,
said first converting means is controlled according to the error signal output from said detecting means, and frequency-converts said input signal into the signal in the first frequency band coinciding with said pass band, and
said second converting means is controlled according to the error signal output from said detecting means and delayed by a delay time taken by processing of said filter, and frequency-converts the signal whose frequency component outside said pass band is cut off by said filter from the frequency band coinciding with said pass band by said first converting means to said second frequency band.

2. The signal processing device according to claim 1,
wherein said input signal is a digital broadcast signal frequency-converted into an intermediate frequency band using a signal oscillated by a predetermined local oscillator,
the pass band of said filter is a baseband as opposed to said intermediate frequency band,
said first converting means includes an oscillator for oscillating a signal whose frequency is controlled according to the error signal output from said detecting means, and a quadrature demodulator for quadrature-demodulating the digital broadcast signal in the intermediate frequency band into the signal in the first frequency band coinciding with the baseband, using the signal oscillated by the oscillator,
said filter cuts off a frequency component in a frequency band higher than said baseband, the frequency component being included in the signal quadrature-demodulated by said first converting means,
said second converting means includes a delay device for delaying the error signal output from said detecting means by the delay time taken by the processing of said filter, an oscillator for oscillating a signal whose frequency is controlled according to the error signal delayed by said delay device, and a quadrature modulator for quadrature-modulating the signal whose frequency component in the frequency band higher than the baseband is cut off by said filter into the signal in the second frequency band coinciding with said intermediate frequency band, using the signal oscillated by said oscillator,
said third converting means includes a quadrature demodulator for quadrature-demodulating the signal in the intermediate frequency band which signal is quadrature-modulated by said second converting means, and a frequency converter for frequency-converting the signal quadrature-demodulated by said quadrature demodulator into the signal in the third frequency band coinciding with said baseband, using the signal oscillated by said oscillating means, and
said detecting means includes a phase error detector for detecting a phase error between a signal point indicated by the signal in the third frequency band which signal is frequency-converted by the third converting means and a signal point transmitted by said digital broadcast signal, and a loop filter for filtering a result of the detection by said phase error detector, and outputting the error signal.

3. The signal processing device according to claim 1,
wherein said input signal is a digital broadcast signal frequency-converted into an intermediate frequency band by a signal oscillated by a predetermined local oscillator,
the pass band of said filter is a baseband as opposed to said intermediate frequency band,
said first converting means includes an oscillator for oscillating a signal controlled according to the error signal output from said detecting means, and a quadrature demodulator for quadrature-demodulating the digital broadcast signal in the intermediate frequency band into the signal in the first frequency band coinciding with the baseband, using the signal oscillated by the oscillator,
said filter cuts off a frequency component in a frequency band higher than said baseband, the frequency component being included in the signal quadrature-demodulated by said first converting means,
said second converting means includes a delay device for delaying the error signal output from said detecting means by the delay time taken by the processing of said filter, an oscillator for oscillating a signal controlled according to the error signal delayed by said delay device, and a frequency converter for frequency-converting the signal whose frequency component in the frequency band higher than the baseband is cut off by said filter into the signal in the second frequency band higher than said baseband by the frequency error indicated by the error signal, using the signal oscillated by said oscillator,
said third converting means includes synchronizing processing means for synchronizing the signal in the second frequency band which signal is frequency-converted by said second converting means with a clock cycle of said digital broadcast signal, and a frequency converter for frequency-converting the signal synchronized with the clock cycle by said synchronizing means into a signal in said baseband, using the signal oscillated by said oscillating means, and
said detecting means includes a phase error detector for detecting a phase error between a signal point indicated by the signal in said baseband which signal is frequency-converted by said third converting means and a signal point transmitted by said digital broadcast signal, and a loop filter for filtering a result of the detection by said phase error detector, and outputting the error signal.

4. A control method of a signal processing device, said signal processing device including
first converting means for frequency-converting an input signal into a signal in a first frequency band,
a filter for cutting off a frequency component outside a predetermined pass band, the frequency component being included in the signal in the first frequency band which signal is frequency-converted by said first converting means,
second converting means for frequency-converting the signal whose frequency component outside the pass band is cut off by said filter from said first frequency band to a second frequency band,
third converting means for converting the signal in the second frequency band which signal is frequency-converted by said second converting means into a signal in a third frequency band coinciding with said pass band,
oscillating means for oscillating a signal used for frequency conversion of said third converting means, and
detecting means for detecting a frequency error between oscillation frequency of the signal oscillated by said oscillating means and frequency of a signal used for frequency conversion from said second frequency band to the third frequency band coinciding with said pass band, and outputting an error signal indicating said frequency error,
said control method comprising the steps of:
said oscillating means being controlled in oscillation frequency according to the error signal output by said detecting means, and oscillating the signal used to frequency-convert said second frequency band to the third frequency band coinciding with the pass band;
said first converting means being controlled according to the error signal output from said detecting means, and frequency-converting said input signal into the signal in the first frequency band coinciding with said pass band; and
said second converting means being controlled according to the error signal output from said detecting means and delayed by a delay time taken by processing of said filter, and frequency-converting the signal whose frequency component outside said pass band is cut off by said filter from the frequency band coinciding with said pass band by said first converting means to said second frequency band.

5. A digital broadcast wave receiving device comprising:
receiving means for receiving a quadrature-modulated digital broadcast wave;
intermediate frequency converting means for converting a signal received by said receiving means into an intermediate frequency band;
quadrature demodulating means for quadrature-demodulating the signal in the intermediate frequency band which signal is frequency-converted by said intermediate frequency converting means;
first converting means for frequency-converting the signal quadrature-demodulated by said quadrature demodulating means into a signal in a first frequency band;
a filter for cutting off a frequency component in a frequency band higher than a baseband, the frequency component being included in the signal in the first frequency band which signal is frequency-converted by said first converting means;
second converting means for frequency-converting the signal whose frequency component in the frequency band higher than the baseband is cut off by said filter into a signal in a second frequency band coinciding with the frequency band frequency-converted by said quadrature demodulating means;
third converting means for converting the signal in the second frequency band which signal is frequency-converted by said second converting means into a signal in a third frequency band coinciding with said baseband;
oscillating means for oscillating a signal used for frequency conversion of said third converting means; and
detecting means for detecting an error between oscillation frequency of the signal oscillated by said oscillating means and frequency of a signal used by said third converting means to frequency-convert the signal in said second frequency band into the signal in the third frequency band coinciding with said baseband, and outputting an error signal indicating said error;
wherein said oscillating means is controlled according to the error signal output by said detecting means, and oscillates the signal used to frequency-convert the signal in said second frequency band to the signal in the third frequency band coinciding with said baseband,
said first converting means is controlled according to the error signal output from said detecting means, and frequency-converts said input signal into the signal in the first frequency band coinciding with said baseband, and
said second converting means is controlled according to the error signal output from said detecting means and delayed by a delay time taken by processing of said filter, and frequency-converts the signal whose frequency component in the frequency band higher than the baseband is cut off by said filter from the frequency band coinciding with said baseband to said second frequency band.

6. A control method of a digital broadcast wave receiving device, said digital broadcast wave receiving device including
receiving means for receiving a quadrature-modulated digital broadcast wave,
intermediate frequency converting means for converting a signal received by said receiving means into an intermediate frequency band,
quadrature demodulating means for quadrature-demodulating the signal in the intermediate frequency band which signal is frequency-converted by said intermediate frequency converting means,
first converting means for frequency-converting the signal quadrature-demodulated by said quadrature demodulating means into a signal in a first frequency band,
a filter for cutting off a frequency component in a frequency band higher than a baseband, the frequency component being included in the signal in the first frequency band which signal is frequency-converted by said first converting means,
second converting means for frequency-converting the signal whose frequency component in the frequency band higher than the baseband is cut off by said filter into a signal in a second frequency band coinciding with the frequency band frequency-converted by said quadrature demodulating means,
third converting means for converting the signal in the second frequency band which signal is frequency-converted by said second converting means into a signal in a third frequency band coinciding with said baseband,
oscillating means for oscillating a signal used for frequency conversion of said third converting means, and
detecting means for detecting an error between oscillation frequency of the signal oscillated by said oscillating means and frequency of a signal used by said third converting means to frequency-convert the signal in said second frequency band into the signal in the third frequency band coinciding with said baseband, and outputting an error signal indicating said error,
said control method comprising the steps of:
said oscillating means being controlled according to the error signal output by said detecting means, and oscillating the signal used to frequency-convert the signal in said second frequency band to the signal in the third frequency band coinciding with said baseband;
said first converting means being controlled according to the error signal output from said detecting means, and frequency-converting said input signal into the signal in the first frequency band coinciding with said baseband; and
said second converting means being controlled according to the error signal output from said detecting means and delayed by a delay time taken by processing of said filter, and frequency-converting the signal whose frequency component in the frequency band higher than the baseband is cut off by said filter from the frequency band coinciding with said baseband to said second frequency band.
